# EUROPEAN PATENT APPLICATION

(11) **EP 2 194 583 A1**
(43) Date of publication of application: **09.06.2010**
(21) Application number: 08170861.2
(22) Date of filing: 05.12.2008
(51) Int. Cl.: H01L 31/0224

(54) **Semiconductor device and method of producing a semiconductor device**

(71) Applicant: Applied Materials, Inc., Santa Clara, CA 95054 (US)
(72) Inventor: Repmann, Tobias, 63755, Alzenau (DE); Straub, Axel, 55218, Ingelheim (DE)
(74) Representative: Lermer, Christoph

(57) **Abstract**

A solar cell module 1 comprises a transparent substrate 2, e.g. a glass substrate. On top of the glass substrate 2 a layer system 3 is deposited. The layer system 3 comprises a front electrode 4 which may be a transparent conductive oxide (TCO) layer. Furthermore, the layer system 3 comprises a thin film semiconductor layer 5 deposited on the front electrode layer 4. A back electrode is formed on the thin film semiconductor layer 5 which includes a very thin metal layer 6 having a thickness d smaller than 50 nm. A Lambertian reflective layer 7 is deposited on the thin metal layer 6 in order to reflect light transmitted through the metal layer 6.

## Description

### TECHNICAL FIELD

The present invention relates to a semiconductor device, particularly a solar cell module, comprising: at least a semiconductor layer for converting light into electric power; at least a back electrode layer deposited on the semiconductor layer; and a reflective layer deposited on the electrode layer. Furthermore, the invention relates to a method of producing a semiconductor device, particularly a semiconductor device as mentioned above, comprising the steps of: a) depositing a semiconductor layer for converting light into electric power on a substrate; b) depositing a back electrode layer on the semiconductor layer; and c) depositing a reflective layer on the back electrode layer.

### PRIOR ART

High prices for fossil energy and environmental pollution increase the demand for photovoltaic devices and solar cell modules permanently. Generally, solar cell modules convert light impinging on the solar cell into electric power. Solar cell modules usually comprise at least a first electrode layer, a thin film semiconductor layer deposited on the first electrode layer, and a second electrode layer deposited on the thin film semiconductor layer. In the semiconductor layer the conversion of light into electric power takes place. The thin film semiconductor layer includes at least two thin conducting areas of different conductivity type and a junction between these areas. The junction may be a p-i-n junction between a p-doped area and an n-doped area. The electrode layers are configured as positive and negative contacts.

Of course, the front electrode layer has to be transparent for light impinging on the solar cell module to enter the semiconductor layer. The back electrode layer may be of any suitable material provided that the material has sufficient conductivity for conducting the electric current generated in the semiconductor layer.

For example, the back electrode layer may be configured as a transparent TCO (transparent conductive oxide) layer. Of course, the TCO layer has to have a thickness sufficient to provide an adequate conductivity of the back electrode. In order to increase the efficiency of the solar cell module a reflective layer is deposited on the back side of the TCO layer in order to reflect light transmitted through the semiconductor layer and the TCO layer back through the TCO layer into the semiconductor layer.

Alternatively, electrically conductive and reflective materials may be used for forming the back electrode layer. It is most common to use metal as back electrode material because metals have good conductivity and reflect the light transmitted through the semiconductor layer back into the semiconductor layer.

### OBJECT OF THE INVENTION

It is an object of the present invention to provide a solar cell module having high efficiency and a method of producing a solar cell module having high efficiency at reduced manufacturing costs.

### TECHNICAL SOLUTION

This object is solved by providing a semiconductor device according to claim 1 and a method of producing a semiconductor device according to claim 9. The dependent claims refer to preferred features of the invention.

A semiconductor device according to the invention, particularly a solar cell module, e.g. a thin film photovoltaic module, comprises: at least a semiconductor layer for converting light into electric power; at least a back electrode layer deposited on the semiconductor layer; and a reflective layer deposited on the electrode layer. The electrode layer is formed as a thin metal layer which is at least partly transparent for light transmitted through the semiconductor layer.

The metal layer has a small thickness which allows at least some of the light transmitted through the semiconductor layer to be transmitted through the metal layer as well. The transmitted light is then reflected by the reflective layer deposited on the other side of the electrode layer. A partial transmission of light through the metal layer may mean that, for example, the transmissibility T is at least 50%, preferably at least 25%, or even more preferably at least 10%. It may also be that the transmissibility T for light is at least as large as the reflectivity R and the absorbability A of the layer.

In conventional solar cell modules transparent conductive oxide layers having a thickness of at least a few 100 nm for providing an adequate conductivity are produced. Due to the thickness of the TCO layers the effort is quite high compared with thin metal coatings according to the present invention.

Alternatively, conventional back contacts may comprise metal layers which are thicker than at least 100 nm in order to provide enough reflectivity of the metal layer. According to the present invention, however, the back electrode metal layer is quite thin thus reducing the production effort and costs for the back electrode. The conductivity of the thin metal layer is sufficient for conducting currents generated e.g. in Si thin layer solar cells due to a high specific conductivity of metals. The thickness of the layer may be less than 10 % of the thickness of conventional layers. The light transmitted through the electrode layer is reflected by the additional reflective layer which is an important feature of the invention.

Furthermore a serial connection of solar modules according to the invention may be provided having a better reliability due to a better adhesion of contacts and more reliable laser scribing.

In a preferred embodiment of the invention the thickness of the back electrode layer is less than 100 nm, particularly less than 50 nm, more particularly less than 10 nm.

It is preferred that the thin metal layer comprises at least Al, Ag, or other metals.

In another preferred embodiment of the invention the semiconductor device comprises at least a first TCO (Transparent Conductive Oxide) layer arranged between the semiconductor layer and the back electrode layer. The first TCO layer may have a small thickness, e.g. 10 nm. The thin metal layer provides the required conductivity to the back electrode which may now be considered as a combination of the first TCO layer and the thin metal layer.

In another preferred embodiment of the invention the semiconductor device may comprise a second TCO layer arranged between the back electrode layer and the reflective layer. The second TCO layer generates a protective layer for the sensitive metal layer. It may have a small thickness of e.g. 10 nm. In this embodiment the electrode may be considered to be a combination of a metal layer and the second TCO layer and/or the first TCO layer. In other words, the metal layer may be sandwiched between the semiconductor layer and the second TCO layer, or between the first TCO layer and the second TCO layer.

It is preferred that the semiconductor device comprises a transparent front electrode layer arranged on the semiconductor layer on a side opposite the back electrode layer. The front electrode layer may be a TCO layer.

It is preferred that the reflective layer is configured as a Lambertian back reflective layer. The luminance of Lambertian reflectors is substantially isotropic. A Lambertian reflector is a layer which comprises white pigments and/or is white coloured.

In a preferred embodiment of the invention the back reflective layer comprises white pigments and /or white colour and/or titanium dioxide embedded in a carrier material.

The method according to the invention of producing a semiconductor device, particularly a semiconductor device as described above, comprises the steps of: a) depositing a semiconductor layer for converting light into electric power on top of a substrate; b) depositing a back electrode layer on the semiconductor layer; and c) depositing a reflective layer on the back electrode layer, wherein the electrode layer is formed as a thin film metal layer having a thickness which is at least partly transparent for light transmitted through the semiconductor layer.

In a preferred embodiment of the invention depositing the back electrode layer in step b) includes depositing a metal layer having a thickness less than 100 nm, particularly less than 50 nm, more particularly less than 10 nm, on top of the semiconductor layer.

In another preferred embodiment of the invention the step of depositing the back electrode layer on top of the semiconductor layer in step b) comprises depositing at least a layer comprising Al and/or Ag.

In another preferred embodiment of the invention the method comprises an additional step a1) of depositing a first TCO layer on top of the semiconductor layer before carrying out step b).

In another preferred embodiment of the invention the method comprises a further step b1) of depositing a second TCO layer on top of the back electrode layer before carrying out step c).

It is preferred step c) includes depositing the reflective layer as a Lambertian back reflective layer.

### BRIEF DESCRIPTION OF THE DRAWING

Further features and advantages of the invention will be apparent from the following description of preferred embodiments with reference to the appended drawings. The figures illustrate:
- Figure 1: a first embodiment of the invention;
- Figure 2: a second embodiment of the invention; and
- Figure 3: a third embodiment of the invention.

### DETAILED DESCRIPTION OF PREFERRED EMBODIMENTS

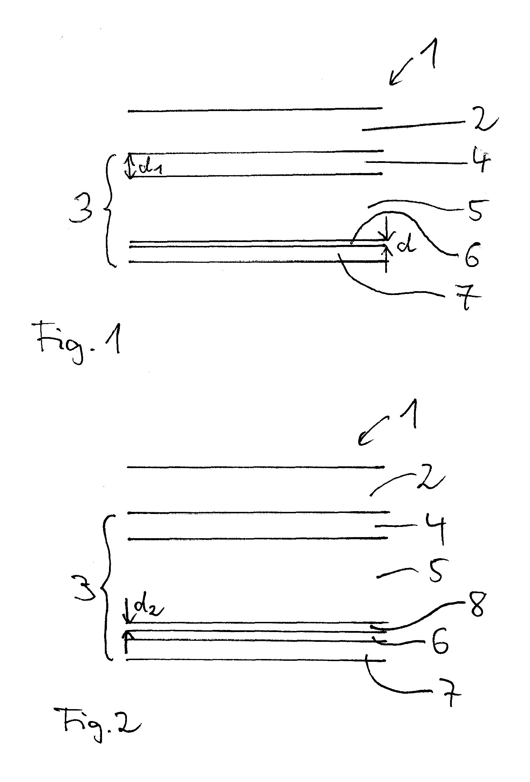

Figure 1 illustrates a first embodiment of a solar cell module 1 according to the present invention.

The solar cell module 1 comprises a transparent substrate 2, e.g. a glass substrate. On top of the glass substrate 2 a layer system 3 is deposited.

The layer system 3 comprises a front electrode 4 of the solar cell module 1. The front electrode 4 may be a transparent conductive oxide (TCO) layer and has a first thickness d₁ of a few 100 nm. The thickness d₁ is sufficient for providing the required conductivity for conducting electric current produced by the solar cell module 1.

Furthermore, the layer system 3 comprises a thin film semiconductor layer 5 deposited on the front electrode layer 4. The thin film semiconductor layer 5 comprises areas of different conductivity type and a junction between these areas in order to convert light into electric power.

According to the invention a back electrode is formed on the thin film semiconductor layer 5 which includes a very thin metal layer 6 having a thickness d smaller than 50 nm. The metal layer has a thickness d sufficient for providing conductivity for transmitting electric current produced by the solar cell module 1. However, the thickness d is so small that most of the light transmitted through the semiconductor layer 5 transmits through the thin metal layer 6.

After transmitting through the thin metal layer 6 the light is reflected by a reflective layer 7 deposited on the thin metal layer 6. In the described embodiment the reflective layer 7 is a white Lambertian reflective layer deposited on the back side of the solar cell module 1.

In order to protect the solar cell module 1 an encapsulation layer or element (not illustrated), e.g. a second glass substrate, may be arranged on the back side of the white Lambertian layer 7.

Figure 2 shows a second embodiment of the present invention. Compared with the first embodiment illustrated in figure 1 the layer system 3 according to the second embodiment comprises an additional first TCO layer 8 which is arranged between the semiconductor layer 5 and the thin metal layer 6. The TCO layer 8 has a thickness d₂ of about 10 nm. The first TCO layer 8 and the thin metal layer 6 form the back electrode of the solar cell module 1.

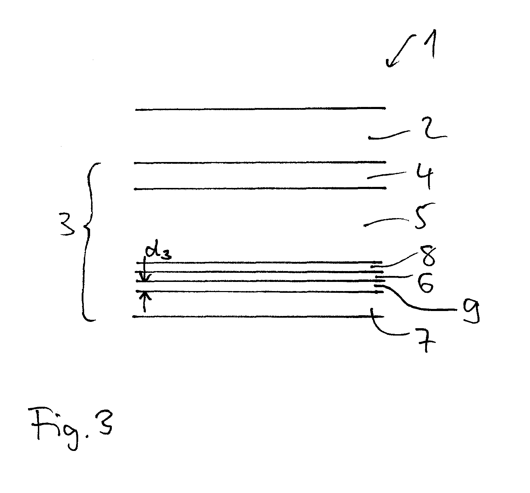

Figure 3 illustrates a third embodiment of the invention. In this embodiment the layer system 3 comprises a first TCO layer 8 arranged between the semiconductor layer 5 and the thin metal layer 6 and a second TCO layer 9 arranged on the back side of the thin metal layer 6 between the thin metal layer 6 and the reflective layer 7. The second TCO layer 9 has a thickness d₃ of about 10 nm. It forms a protective layer for protecting the thin metal layer 6 from environmental influences.

The first TCO layer 8, the second TCO layer 9 and the thin metal layer 6 sandwiched between the first TCO layer 8 and the second TCO layer 9 form the back electrode of the solar cell module 1.

The embodiments illustrated in figures 1 to 3 are just exemplary. For instance, additional layers may be included. Furthermore, referring to figure 3, the first TCO layer may be abandoned leaving a layer system 3 consisting of the first electrode layer 4, the semiconductor layer 5, the thin metal layer 6, the second TCO layer 9 and the reflective layer 7.

## Claims

1. A semiconductor device (1), particularly a solar cell module, comprising:
at least a semiconductor layer (5) for converting light into electric power;
at least a back electrode layer (6) deposited on the back side of said semiconductor layer (5); and
a reflective layer (7) deposited on said back electrode layer (6),
**characterized in that**
said back electrode layer (6) is formed as a thin metal layer having a thickness (d) which is at least partly transparent for light transmitted through said semiconductor layer (5).

2. The semiconductor device (1) according to claim 1, **characterized in that**
a thickness (d) of said back electrode layer (6) is less than 100 nm, particularly less than 50 nm, more particularly less than 10 nm.

3. The semiconductor device (1) according to claim 1 or 2, **characterized in that**
said thin metal layer comprises at least Al and/or Ag.

4. The semiconductor device (1) according to any of the previous claims, **characterized in that**
said semiconductor device (1) comprises at least a first TCO (Transparent Conductive Oxide) layer (8) arranged between said semiconductor layer (5) and said back electrode layer (6).

5. The semiconductor device (1) according to any of the previous claims, **characterized in that**
said semiconductor device (1) comprises at least a second TCO (Transparent Conductive Oxide) layer (9) arranged between said semiconductor layer (5) and said reflective layer (7).

6. The semiconductor device (1) according to any of the previous claims, **characterized in that**
said semiconductor device (1) comprises a transparent front electrode layer (4) arranged on a front side said semiconductor layer (5).

7. The semiconductor device (1) according to any of the previous claims, **characterized in that**
said reflective layer (7) is configured as a Lambertian reflective layer.

8. The semiconductor device (1) according to any of the previous claims, **characterized in that**
said reflective layer (7) comprises white pigments and /or white colour and/or titanium dioxide embedded in a carrier material.

9. A method of producing a semiconductor device (1), particularly a semiconductor device (1) according to any of the claims 1 to 8, comprising the steps of:
a. depositing a semiconductor layer (5) for converting light into electric power on top of a substrate (2);
b. depositing a back electrode layer (6) on said semiconductor layer (5); and
c. depositing a reflective layer (7) on top of said back electrode layer (6),
**characterized in that**
said back electrode layer (6) is formed as a thin film metal layer having a thickness
(d) which is at least partly transparent for light transmitted through said semiconductor layer (5).

10. The method according to claim 9, **characterized in that**
depositing the back electrode layer (6) in step b) includes depositing a metal layer having a thickness (d) less than 100 nm, particularly less than 50 nm, more particularly less than 10 nm, on top of said semiconductor layer (5).

11. The method according to claim 9 or 10, **characterized in that**
depositing the back electrode layer (6) on top of said semiconductor layer (5) in step b) includes depositing at least a layer comprising Al and/or Ag.

12. The method according to any of the previous claims 9 to 11, **characterized in that**
said method comprises an additional step a1) of depositing a first TCO layer (8) on top of said semiconductor layer (5) before carrying out step b).

13. The method according to any of the previous claims 9 to 12, **characterized in that**
said method comprises an additional step b1) of depositing a second TCO layer (9) on top of said back electrode layer (6) before carrying out step c).

14. The method according to any of the previous claims 9 to 13, **characterized in that**
said method step c) includes depositing said reflective layer (7) as a Lambertian back reflective layer.
